# EUROPEAN PATENT SPECIFICATION

(11) **EP 1 184 903 B1**
(45) Date of publication and mention of the grant of the patent: **28.07.2004**
(21) Application number: 00118804.4
(22) Date of filing: 30.08.2000
(51) Int. Cl.: H01L 21/768

(54) **Method for forming a self-aligned dual damascene interconnection**
Herstellung einer selbst-justierten Doppel-Damaszener-Verbindung
Méthode de formation d'une interconnexion par procédé de double damasquinage à auto-alignement

(43) Date of publication of application: 06.03.2002
(73) Proprietor: MOTOROLA, INC., Schaumburg, IL 60196 (US)
(72) Inventor: Charles, Alain, Bauhinia Court 03-20, Singapore 589627 (SG); Mautz, Karl, 01326 Dresden (DE); Maltabes, John, 01277 Dresden (DE); Petrucci, Joe, 01309 Dresden (DE)
(74) Representative: Wharmby, Martin Angus

(56) References cited:
- US-A- 5 614 765
- US-A- 5 801 099
- US-A- 5 933 761
- US-A- 5 989 997

## Description

### Field of the Invention

The present invention generally relates to semiconductor device manufacture, particularly to the manufacturing of high-density, high-performance semiconductor devices having dual damascene interconnects.

### Background of the Invention

Semiconductor devices, particularly very large scale integration (VLSI) and ultra-large scale integration (ULSI) circuits these days require a very large number of interconnections in the semiconductor substrate to satisfy the increased requirements for density and performance.

The interconnections are made between passive and active devices within a substrate, as well as between a multitude of wiring layers constituting the circuits on a substrate.

High-density demand for such wiring requires planarized layers with minimal spacing between conductive wiring lines.

Traditionally, such interconnection structures have been formed by subtractive etching or etch-back processes. In such processes, an insulating layer, such as an oxide layer, is formed on the semiconductor substrate, with conductive contacts/vias formed in the insulating layer. A metal layer is deposited on the insulating layer and a photoresist pattern is formed on the metal layer, corresponding to the wiring pattern. After etching, a dielectric layer is applied to the resulting wiring pattern.

However, after filling in the spaces between the conductive wiring, it is extremely difficult to form a planarized layer, for example, by chemical-mechanical polishing (CMP).

Furthermore, such etching techniques often result in the formation of voids between interconnection wiring, and impurities or volatile materials may be trapped in or get into wiring spaces.

Other problems, such as the formation of metal shorts, low yields, uncertain reliability and poor ULSI extendibility have also been identified with devices manufactured using such etching techniques.

The damascene process has been developed to simplify and improve the forming of interconnections in a semiconductor substrate. 'Damascene' essentially involves the formation of a trench which is filled in with a metal, e.g., copper, followed by planarization, as opposed to traditional etch-back techniques which involve building up a metal wiring layer and filling in the inter-wiring spaces with a dielectric material.

The damascene process is useful in attaining the fine geometry metallization required for advanced semiconductor devices.

In a single damascene process, grooves are formed in an insulating layer and filled with metal to form conductive lines. This process results in a single conductive opening, e.g. a conductive via.

This single damascene technique provides improved planarization over the known etching techniques. However, when several layers and interconnections are required, this process is time-consuming. Furthermore, an interface results between the conductive via and conductive wiring. Furthermore, it is not possible to contain adequate planarized layers with very small inter-wiring spaces required in high-density circuits.

An improvement on the single damascene technique is the 'dual damascene' process in which, in addition to forming the grooves as in the single damascene, the conductive hole openings are also formed in the insulating layer. The resulting composite structure of grooves and holes are filled with metal. The process is repeated as many times as required to form the multilevel interconnects between metal lines and the holes formed in-between. Contact holes are formed directly over the substrate where the metal in the hole contacts the surface of the substrate, while the via holes are formed between metal layers.

As the opening for the wiring of the metallization level and the underlying vias connecting the wire to a lower metallization level are formed at the same time, the number of process steps for a given metallization level is reduced. Furthermore, this procedure provides an advantage in lithography and allows for improved critical dimension control.

In the standard dual damascene process, for example, the insulating layer is coated with a resist material which is exposed to a first mask with the image pattern of the via opening and the pattern is etched to form an opening for the via. After removal of the resist material, the insulating layer is coated with another resist material exposed to a second mask, which, after etching, forms a second opening corresponding to the desired trench pattern. This process can then be repeated to form several layers, as desired. Variations of the process are possible.

Dual damascene modules are used mainly for copper based metallization and interconnects for the back end of line processes in IC device manufacturing. Copper metal layers cannot normally be plasma-etched and, therefore, must be patterned by channels in the inter-metal dielectric layers (oxide or low k materials).

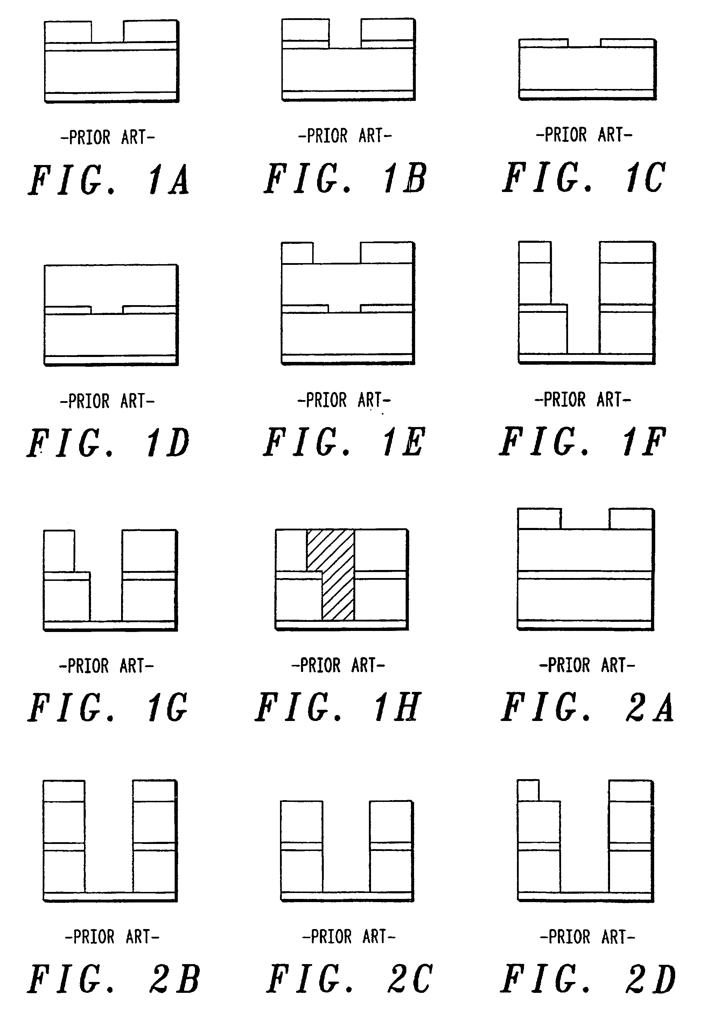

Three alternative dual damascene processes currently used will now be described, with reference to FIGS. 1, 2 and 3 respectively.

The self-aligned dual damascene process involves first coating the insulating layer with a resist material which is exposed to a first mask with the image pattern of the via. The pattern is etched (step 2) and, in step 3, the resist is removed. Next, a further oxide layer is deposited on top of the structure. This layer is then coated with a resist material exposed to a second mask with the image pattern of the trench. This is then etched (step 6) and the resist removed (step 7). The resulting space is then filled with metal, e.g. copper, and subjected to a chemical-metal-polishing (CMP) process.

The advantage of this system is that it uses a simple principle and enables lithography on a planarized surface. However, a disadvantage is that the process requires a thick intermediate stopping layer with a high k value. Furthermore, there is a very small process window between a good corner SiN selectivity and low microloading and no etch stop at higher aspect ratios, e.g. in the case of a stacked via.

Furthermore, this process is highly sensitive to any misalignment between line and via lithography.

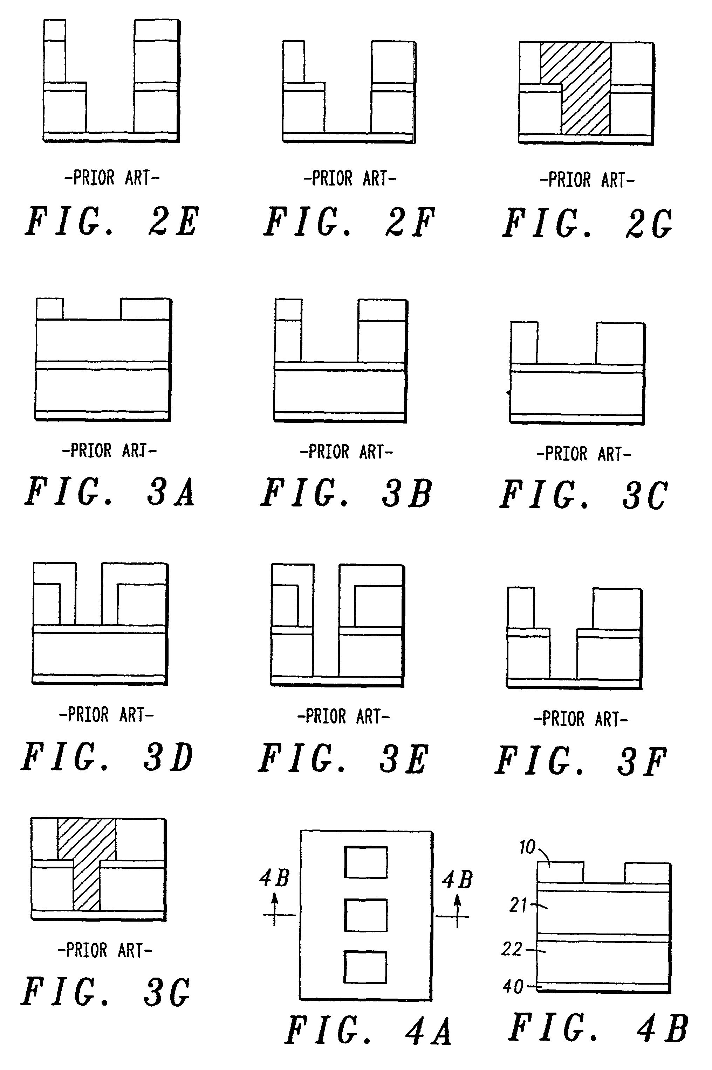

A second known dual damascene process is the 'via first dual damascene' process shown in Fig. 2. Here, the via is etched through two or more insulating layers, after which the trench is etched and the resulting space is then filled with metal.

This process is less demanding from a lithography alignment point of view, and the process can be carried out using a thinner stopping layer or even without any stopping layer at all.

However, the vias have higher aspect ratios and the etching requirements are stringent. Furthermore, problems may arise when organic BARC is used, as residues in the vias can lead to crown defects that cause contact resistance problems.

In a third process, known as the 'trench first' process, the trench is first etched into the upper layer, after which the via is etched through the layers and, again, the structure is then filled with copper and polished.

This process is less demanding from an etching point of view and an intermediate nitride layer is not necessarily needed. However, forming the via lithography pattern over the trench is difficult, as this is not a planar surface and a large depth of focus is required.

The present invention seeks to provide a simplified dual damascene process which is less lithography and etch intensive. The invention provides a system in which the trench is self-aligned to the via structure located below the trench, resulting in improved metal conductor coverage. Furthermore, the invention seeks to mitigate or avoid the problems mentioned above associated with the prior art systems, and other disadvantages and limitations of the prior art.

US 6,042,999 discloses a robust dual damascene process where the substructure in a substrate is protected from damage caused by multiple etchings required in a damascene process by filling a contact or via hole opening with a protective material prior to the forming of the conductive line opening of the damascene structure having an etch-stop layer separating a lower and an upper dielectric layer. In a first example, the protective material is partially removed from the hole opening reaching the substructure prior to the forming of the upper conductive line opening by etching. In a second example, the protective material in the hole is removed at the same time the upper conductive line opening is formed by etching. In a third example, the disclosed process is applied without the need of an etch-stop layer for the dual damascene process.

### Brief Description of the Drawings

- FIG. 1: illustrates a prior art self-aligned dual damascene process;
- FIG. 2: illustrates a prior art 'via first' dual damascene process;
- FIG. 3: illustrates a prior art 'trench first' dual damascene process;
- FIGS. 4-12: illustrate by simplified views from above and cross-section views a method of forming an electrically conductive interconnection between layers in a multilayer semiconductor device according to the present invention;
- FIGS. 13-21: illustrate an embodiment outside the present invention; and
- FIG. 22: illustrates a simplified flow chart diagram of the method.

### Detailed Description of a Preferred Embodiment

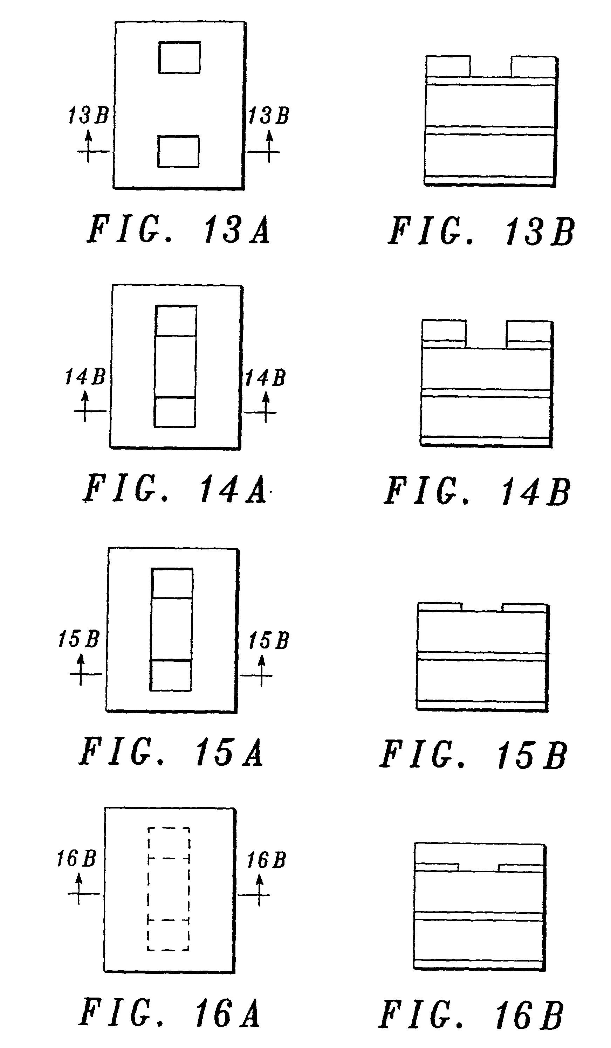

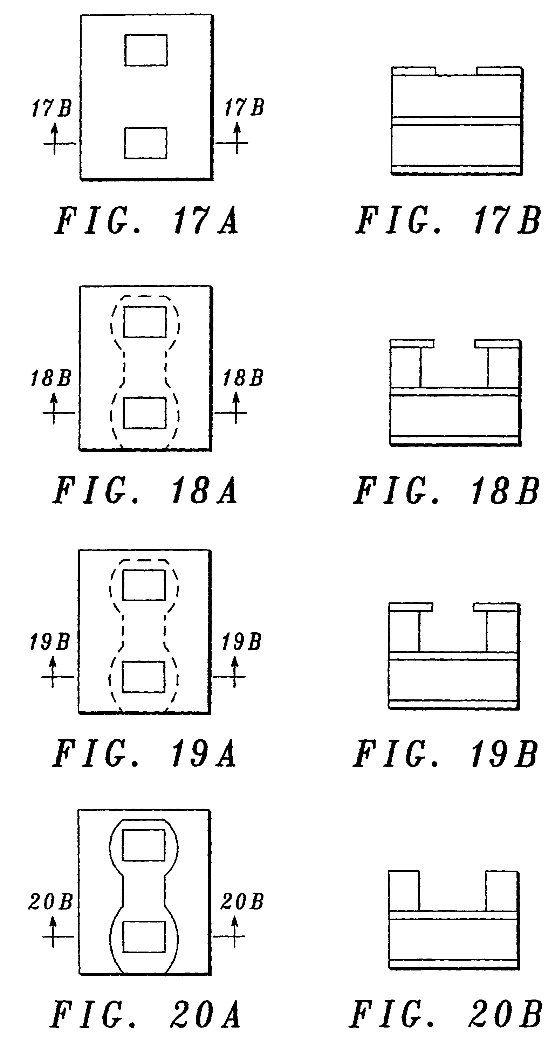

FIGS. 4-12 illustrate method 200 according to the present invention of forming an electrically conductive interconnection between layers in a multilayer semiconductor device by simplified views from above (A) and cross-section views (B). FIGS. 4-12 illustrate the invention and FIGS. 13-21 illustrate an embodiment outside the present invention. The figures illustrate: insulating layers 21, 22 (on a wafer), resist pattern 10 (on upper surface of layer 21), passage 30 (later converted into trench 60 and via 35), metal structure 40, photoresist material 50, 51, hardmask layer 70, etch stop 71, metal 80, hard mask 90, multilayer semiconductor device 100 (provided by the method) as well as the remaining height H of resist material 51, the depth D of trench 60; width W of passage 30, width W1 of via 35, and width W2 of trench 60. Preferred materials are: silicon oxide for layers 21, 22, silicon nitride for hardmask 90, and copper as metal 80.

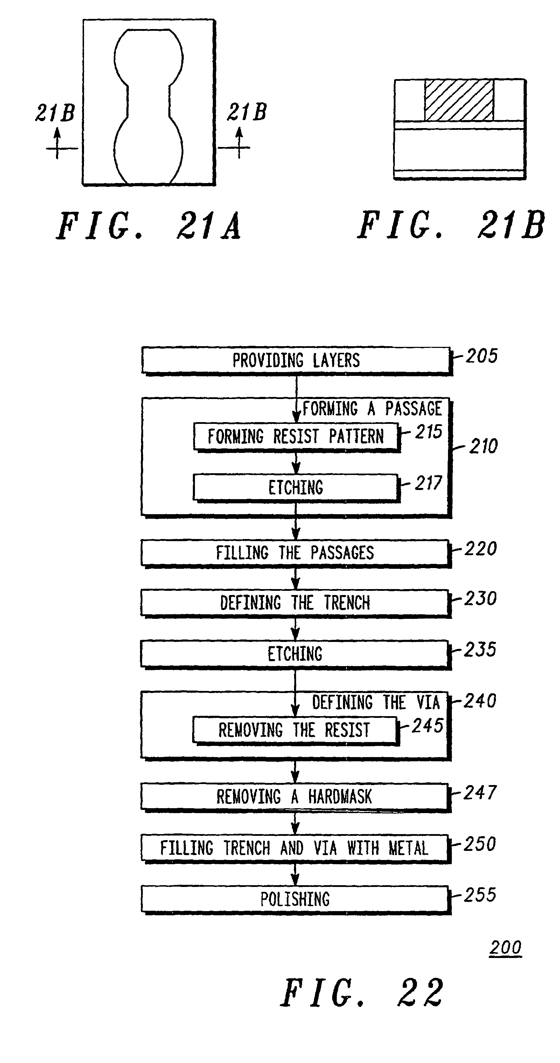

FIG. 22 illustrates a simplified flow chart diagram of method 200. FIG. 22 illustrates the following steps: providing layers 205; forming 210 a passage (e.g., with forming 215 resist pattern, etching 217); filling 220 the passage; defining 230 a trench (e.g., with etching 235); defining 240 a via (e.g., by removing 245 the resist); removing 247 a hardmask; filling 250 trench and via with metal; and polishing 255. However, not all steps shown are required.

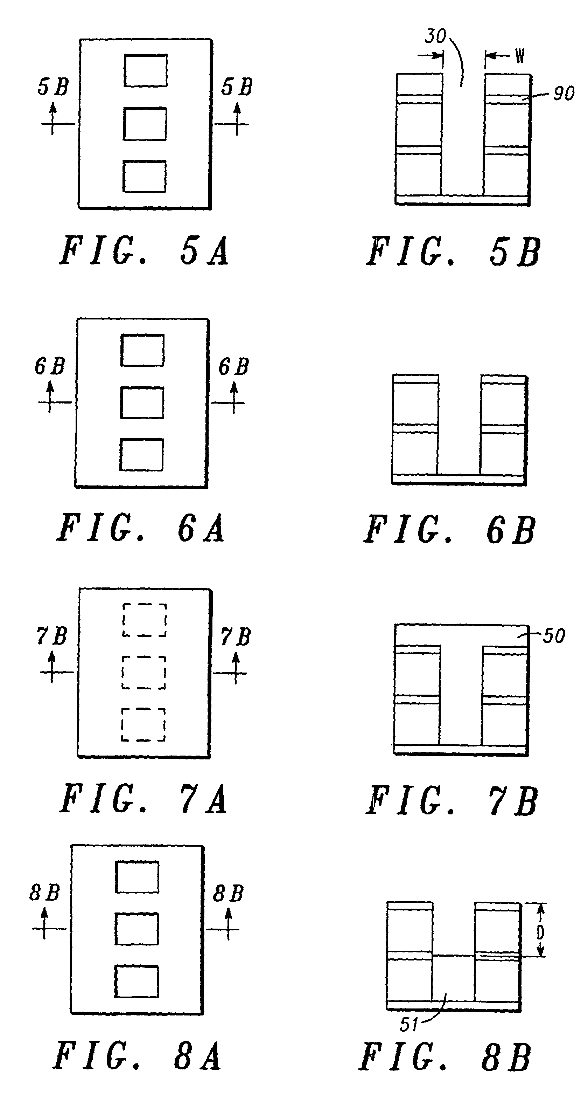

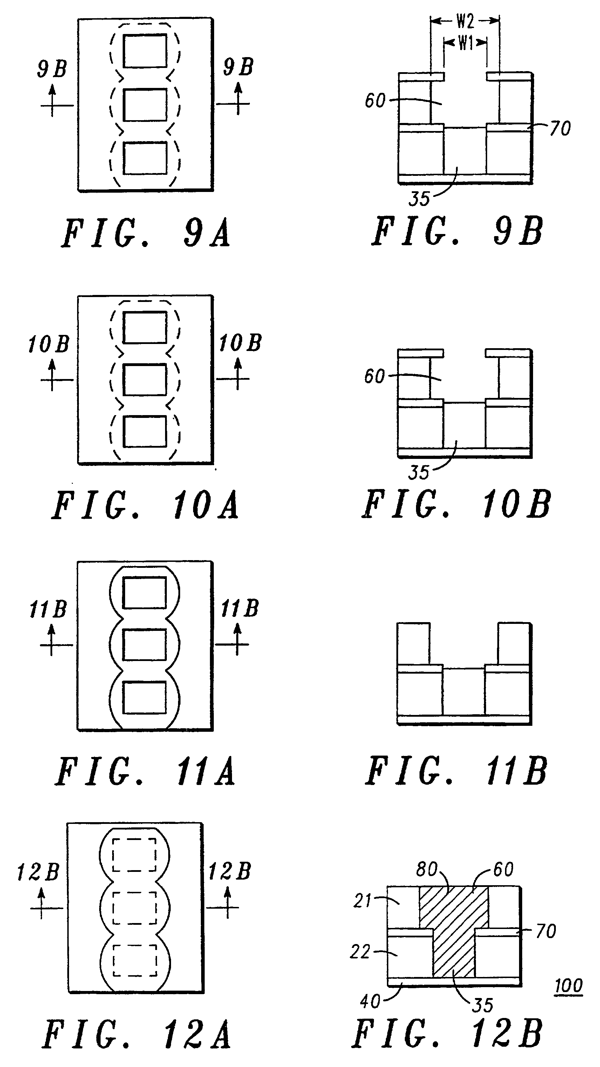

In short, method 200 of forming an interconnection between two insulating layers 21 and 22 is described with the steps forming 210 passage 30 through layers 21, 22 by etching 217 through layers 21, 22 (cf. FIGS. 4-6); filling 220 passage 30 with resist material 51 up to predetermined height H i.e. up to hardmask 70 between layers 21, 22 (cf. FIGS. 7-8); defining 230 trench 60 by further etching 235 passage 30, depth D of trench 60 being defined by the height H of resist material 51 (cf. FIG. 9); defining 240 via 35 by removing 245 resist material 51 (cf. FIG. 10); and filling 250 trench 60 and via 35 with metal 80 (cf. FIG. 12).

Preferably, forming 210 passage 30 comprises defining a via pattern by forming resist pattern 10 on the upper surface of layers 21, 22 (cf. FIG. 4-5).

Optionally, the width W of passage 30 is defined by hard mask 90 (cf. FIG. 5), and wherein mask 90 is removed 247 prior to filling 250 trench 60 and via 35 with metal 80 (cf. FIG. 8).

Preferably, polishing 255 is performed on the resulting structure (layers 21, 22, via 35, trench 60, metal 80, cf. FIG. 9); chemical-mechanical polishing (CMP) is convenient.

FIG. 12 illustrates multilayer semiconductor device 100 that is provided by method 200. Device 100 comprises lower insulating layer 22, upper insulating layer 21, via hardmask layer 70, via 35 having width W1 (cf. FIG. 9) and trench 60 having width W2. In device 100, via hardmask layer 70 is disposed between lower 22 and upper 21 layers and defines width W1, trench 60 is aligned with via 35, width W2 is greater than width W1 and trench 60 is symmetrical to via 35, and via 35 and trench 60 are filled with metal 80.

For the invention, the method is explained with more detail in the following:

Referring first to FIGS. 4-12, which show the steps involved in the self-aligned maskless trench dual damascene process of the present invention, first, the via lithography process step (cf. 215) is carried out with the photoresist-patterned structure 10 on top of the oxide film stack which is composed of layers 21, 22 of TEOS, f-TEOS or other low k dielectric film and various accessory layers such as ARCs or etch stop films.

Next, in the via etch process (cf. 217), a passage 30 is etched through the various layers, down to the underlying metal structures 40. The patterned photoresist strip 10 is then cleaned away (cf. 245).

Next, a layer of photoresist or resin 50 coats the surface, at a desired thickness, filling the passage which has just been etched. This resin or other ashable spin-on film may not require a hard bake, for example the resin can be formulated with a casting solvent which allows adequate spin coverage but is quick setting, such that a bake is not required. In this case, a less complex coating tool can be used (as opposed to using a photoresist track which needs to support an exposure tool).

Next, the wafer is processed e.g. in an ash tool with a descum process, having a low controllable ash rate with good uniformity across the wafer, to remove the resin or photoresist down to a controlled depth D within the passage profile (as seen in FIG. 8). This process could be, for example, a timed process or use optical or interferometric endpointing. The depth of resin removal into the via is determined by the thickness of the upper dielectric film 21 and the degree of tapering required for it.

The next step (cf. 235) involves a high selectivity isotropic oxide etch process to etch away the upper layers where the photoresist or resin is not present forming a trench 60. Preferably, etching is performed as isotropic etching or by a liquid chemical etch agent.

The process of the present invention results in the self-alignment of the trench 60 with the passage structure 30 and creates the trench itself without any patterning, i.e. without the need for a mask for the trench.

An etch stop 70 (composed of films such as silicon oxinitride or silicon nitride) is provided between the dielectric oxide layers to prevent etching, in the trench etching step, into the lower oxide film, or to be used as an endpointing reference.

The trench etch process can be done with an ash tool that has isotropic oxide etch capability, or with a medium to low density plasma oxide etch tool.

The facet (defined as a rounded upper section with vertical profile) or taper (continuous or curved slope to bottom) angle and the depth are controlled by the etch process to produce the required trench size. By adjusting the degree of anisotropic oxide etch behavior, the profile can be vertically tapered and the critical dimensions in the upper oxide film can be controlled. Furthermore, the facet taper can be controlled by the depth of the upper dielectric oxide film and the subsequent CMP oxide thickness removed. A slight taper may be advantageous for the subsequent copper fill process.

After the trench 60 has been etched, the resin or photoresist 51 left in the passage is removed (cf. 245) by ashing and possibly solvent cleaning to ensure that no organic material remains on the bottom surface. Removing is controllably down to the predetermined depth (e.g., by a timed process). Removing is, preferably, performed by an etch back step or by a recess step.

The wet cleaning chemistry or process could also be used to modify the passage, e.g. by surface roughening or affecting the surface state, to promote adhesion of the copper seed or film, when added.

In the next stage, the copper metal deposition 80 is completed in the via and trench. In an alternative processing scheme, via plug structures could be provided using tungsten or other associated films such as titanium nitride, prior to the copper deposition step. Following this, the metal CMP process is completed to fully define the copper linewidth in the trench. This completes the backend process module for this metallization layer. The process can be repeated for additional metallization steps, to complete the entire backend sequence for that device.

The resulting outline is, as can be seen, rounded. This could be corrected by changing the contact shapes.

During the process, a top hard mask 90 (cf. FIG. 10) can be formed defining the via. This would be removed prior to the copper filling step. However, this hard mask is not required.

The above-described process works well with chained or group via structures. Where isolated via structures are required to be connected to other grouped or isolated vias, the process as shown in FIGS. 13-21 can be used, to facilitate the copper linewidth connection. These areas may be connected by printing in narrower lines between the vias. This will result in the oxide etching to a depth less than the via. An etch stop between the dielectric films may be used to prevent penetration to the lower dielectric film, especially where there are other previously defined structures below this level. This would allow a series of vias to be printed that would stop at this level. Another possible method is to print additional vias that are smaller and more closely spaced than the original vias. This will not result in fully etched vias, to the normal depth, but would form shallow, wider vias which would form a trench line, like a trough, that would be filled by the copper to form a linewidth.

In one embodiment, the resin ash, oxide etch and copper seed deposition process steps could be accomplished in a single multi-chambered platform. This would result in a reduction of processing time and would also decrease the risk of contamination and reduce the risk of defects.

Furthermore, an in-situ metrology unit could be installed in such a platform to provide measurements so as to ensure proper clearing, i.e. film etching, proper etch depth, and to ensure contamination-free surfaces (i.e. no ash residuals or particles). In the case of the embodiment using the metrology application, it would also be necessary to provide a global wafer alignment module, for additional wafer alignment, and a pattern map of sample locations for measurement, programmed in the embedded metrology software routines.

The process according to the present invention is advantageous in that it requires only one lithography alignment step on the planar surface.

It replaces a difficult coating/ exposure/ development process required in the prior art with a simple coating/resist/recess process. The resulting trench is truly self-aligned with the via.

The facet and angle of the trench can be easily tuned and adjusted to optimize the metal filling.

Furthermore, as mentioned above, the resist ash, oxide etch and copper deposition steps could be carried out on a single multi-chambered platform.

Thus, effectively, one lithography exposure step per metallization layer is eliminated and the associated etch process can be done in a less complex etch tool. The resulting interconnect structure is precise and aligned, even with very dense structures.

To summarize the invention, the method of forming electrically conductive horizontal and vertical interconnections comprises the steps of claim 1. While the invention has been described in terms of particular structures, devices and methods, those of skill in the art will understand based on the description herein that it is not limited merely to such examples and that the full scope of the invention is properly determined by the claims that follow.

## Claims

1. A method (200) of forming an electrically conductive interconnection, said method comprising:
forming (205) a hardmask (70) between two dielectric layers (21, 22);
forming (210) a passage (30) through said layers and hardmask by etching through said layers and hardmask, said method further **characterized by**:
filling (220) said passage with a resist material (51) up to said hardmask (70);
defining (230) a trench by isotropic etching said passage, the depth of said trench being defined by the height of said resist material;
defining (240) a via (35) by removing said resist material; and
filling (250) said trench and said via with metal (80).

2. The method according to claim 1, wherein said isotropic etching is performed as plasma etching.

3. The method according to claim 1, wherein said isotropic etching is performed by a liquid chemical etch agent.

4. The method according to claim 1, wherein said step of forming (210) said passage (30) comprises defining a via pattern by forming (215) a resist pattern (10) on the upper surface of said layers (21, 22).

5. The method according to claim 1, wherein a width (W) of said passage (30) is defined by a mask (90), and wherein said mask (90) is removed (247) prior to the step of filling (250) said trench (60) and said via (35) with the metal (80).

6. The method according to claim 1, further comprising the step of polishing (255) the resulting structure using chemical-mechanical polishing (CMP).

7. The method according to claim 1, wherein the step of filling (220) said passage (30) with resist material (51) comprises substantially completely filling (220) the passage (30) with said resist material (51) and then controllably removing (245) said resist material down to said predetermined depth.

8. The method according to claim 7, wherein said removing is performed by an etch back step.

9. The method according to claim 7, wherein said removing is performed by a recess step.

10. The method according to claim 7, wherein said controllably removing is performed by a timed process.

11. The method according to claim 7, wherein said controllably removing involves optical or interferometric endpointing.

12. The method of claim 1 further comprising providing a single multi-chambered platform to perform said method in.

13. The method of claim 12 further comprising using an in-situ metrology unit to provide measurements during said method.

## Patentansprüche

1. Verfahren (200) zum Bilden einer elektrisch leitenden Verbindung, wobei das Verfahren folgendes umfasst:
Bilden (205) einer Hartmaske (70) zwischen zwei dielektrischen Schichten (21, 22);
Bilden (210) eines Durchlasses (30) durch die Schichten und die Hartmaske durch Ätzen durch die Schichten und die Hartmaske, wobei das Verfahren weiter **gekennzeichnet ist durch**:
Füllen (220) des Durchlasses mit einem Resistmaterial (51) bis herauf zu der Hartmaske (70);
Definieren (230) einer Rinne **durch** isotropes Ätzen des Durchlasses, wobei die Tiefe der Rinne **durch** die Höhe des Resistmaterials definiert wird;
Definieren (240) eines Via (35) **durch** Entfernen des Resistmaterials; und
Füllen (250) der Rinne und des Via mit Metall (80).

2. Verfahren gemäß Anspruch 1, bei dem das isotrope Ätzen als Plasmaätzen durchgeführt wird.

3. Verfahren gemäß Anspruch 1, bei dem das isotrope Ätzen durch ein flüssiges chemisches Ätzagens durchgeführt wird.

4. Verfahren gemäß Anspruch 1, bei dem der Schritt des Bildens (210) des Durchlasses (30) das Definieren eines Viamusters durch das Bilden (215) eines Resistmusters (10) auf der Oberfläche der Schichten (21, 22) umfasst.

5. Verfahren gemäß Anspruch 1, bei dem eine Breite (W) des Durchlasses (30) durch eine Maske (90) definiert wird, bei dem die Maske (90) vor dem Schritt des Füllens (250) der Rinne (60) und des Via (35) mit dem Metall (80) entfernt wird (247).

6. Verfahren gemäß Anspruch 1, das weiterhin den Schritt des Polierens (255) der resultierenden Struktur durch Verwenden von chemisch-mechanischem Polieren (CMP) umfasst.

7. Verfahren gemäß Anspruch 1, bei dem der Schritt des Füllens (220) des Durchlasses (30) mit dem Resistmaterial (51) das im Wesentlichen vollständige Füllen (220) des Durchlasses (30) mit dem Resistmaterial (51) und dann das gesteuerte Entfernen (245) des Resistmaterials herunter bis zu der vorbestimmten Tiefe umfasst.

8. Verfahren gemäß Anspruch 7, bei dem das Entfernen durch einen Etch-Back-Schritt durchgeführt wird.

9. Verfahren gemäß Anspruch 7, bei dem das Entfernen durch einen Recess-Schritt durchgeführt wird.

10. Verfahren gemäß Anspruch 7, bei dem das gesteuerte Entfernen durch ein zeitgesteuertes Verfahren durchgeführt wird.

11. Verfahren gemäß Anspruch 7, bei dem das gesteuerte Entfernen eine optische oder interferometrische Endpunktbestimmung ("end pointing") umfasst.

12. Verfahren gemäß Anspruch 1, das weiterhin eine einzelne Mehrkammerplattform umfasst, um das Verfahren darin durchzuführen.

13. Verfahren gemäß Anspruch 12, das weiterhin das Verwenden einer in-situ-Messeinheit umfasst, um Messungen während des Verfahrens zur Verfügung zu stellen.

## Revendications

1. Procédé (200) de formation d'une interconnexion conductrice de l'électricité, ledit procédé comprenant les étapes qui consistent à :
former (205) un masque rigide (70) entre deux couches diélectriques (21, 22) ;
former (210) un passage (30) à travers lesdites couches et ledit masque rigide, par une gravure à travers lesdites couches et ledit masque, ledit procédé étant, en outre, **caractérisé par** les étapes qui consistent à :
remplir (220) ledit passage avec un résist (51) jusqu'audit masque rigide (70) ;
définir (230) une tranchée par une gravure isotrope dudit passage, la profondeur de ladite tranchée étant définie par la hauteur dudit résist ;
définir (240) un via (35) par élimination dudit résist ; et
remplir (250) ladite tranchée et ledit via d'un métal (80).

2. Procédé selon la revendication 1, dans lequel ladite gravure isotrope est effectuée sous la forme d'une gravure par plasma.

3. Procédé selon la revendication 1, dans lequel ladite gravure isotrope est effectuée par un agent de gravure chimique liquide.

4. Procédé selon la revendication 1, dans lequel ladite étape de formation (210) dudit passage (30) comprend la définition d'un motif de via par la formation (215) d'un motif de résist sur la surface supérieure desdites couches (21, 22).

5. Procédé selon la revendication 1, dans lequel une largeur (W) dudit passage (30) est définie par un masque (90), et dans lequel ledit masque (90) est éliminé (247) avant l'étape de remplissage (250) de ladite tranchée (60) et dudit via (35) avec le métal (80).

6. Procédé selon la revendication 1, comprenant, en outre, l'étape de polissage (255) de la structure obtenue, à l'aide d'un polissage chimico-mécanique (CMP).

7. Procédé selon la revendication 1, dans lequel l'étape de remplissage (220) dudit passage (30) avec un résist (51) comprend les opérations qui consistent à remplir (220) essentiellement complètement le passage (30) avec ledit résist (51), puis à éliminer (245) d'une manière contrôlable ledit résist, jusqu'à ladite profondeur prédéterminée.

8. Procédé selon la revendication 7, dans lequel ladite élimination est effectuée par une étape de rétrogravure.

9. Procédé selon la revendication 7, dans lequel ladite élimination est effectuée par une étape d'évidement.

10. Procédé selon la revendication 7, dans lequel ladite élimination d'une manière contrôlable est effectuée par un procédé minuté.

11. Procédé selon la revendication 7, dans lequel ladite élimination de manière contrôlable met en jeu une mesure finale optique ou interférométrique.

12. Procédé selon la revendication 1, comprenant, en outre, la prévision d'une unique plateforme à plusieurs chambres pour y exécuter le procédé.

13. Procédé selon la revendication 12, comprenant, en outre, l'utilisation d'une unité de métrologie in situ pour la prise de mesures pendant ledit procédé.
